# EUROPÄISCHE PATENTSCHRIFT

(11) **EP 1 236 270 B1**
(45) Veröffentlichungstag und Bekanntmachung des Hinweises auf die Patenterteilung: **09.06.2004**
(21) Anmeldenummer: 00993294.8
(22) Anmeldetag: 27.11.2000
(51) Int. Cl.: H03C 3/09

(54) **SENDEVORRICHTUNG**
TRANSMITTING DEVICE
DISPOSITIF D'EMISSION

(30) Priorität: 02.12.1999 DE 19958206
(43) Veröffentlichungstag der Anmeldung: 04.09.2002
(73) Patentinhaber: Infineon Technologies AG, 81669 München (DE)
(72) Erfinder: HADJIZADA, Abdul-Karim, 40882 Ratingen (DE); KRANZ, Christian, 40885 Ratingen (DE)
(74) Vertreter: Graf Lambsdorff, Matthias, Dr.
(86) Internationale Anmeldenummer: PCT/DE2000/004239
(87) Internationale Veröffentlichungsnummer: WO 2001/041296

(56) Entgegenhaltungen:
- EP-A- 0 961 412
- WO-A-86/00767
- US-A- 5 027 087
- US-A- 5 483 203

## Beschreibung

Die vorliegende Erfindung betrifft eine Sendevorrichtung, bei der Sendedaten auf ein Trägersignal aufmoduliert werden, nach dem Oberbegriff des Anspruches 1.

In Sendevorrichtungen ("Transmitter"), bei denen Sendedaten auf eine Trägerfrequenz aufmoduliert werden, ist der bei der Modulation realisierbare Modulationshub begrenzt, da davon die Sendebandbreite abhängt. Daher muß sichergestellt werden, daß sich der Modulationshub stets innerhalb bestimmter Grenzen befindet.

Bekannte Sendevorrichtungen nach dem Oberbegriff des Anspruches 1 umfassen eine Einrichtung zur Erzeugung eines von den Sendedaten abhängigen Modulationssignals sowie eine von dem Modulationssignal angesteuerte Einrichtung, welche eine dem Modulationssignal entsprechende HF-Sendefrequenz erzeugt. Bei der letztgenannten Einrichtung kann es sich insbesondere um einen spannungsgesteuerten Oszillator ("Voltage Controlled Oscillator", VCO) handeln, dem ein über einen Phasenregelkreis ("Phase Locked Loop", PLL) geregeltes Steuersignal zugeführt wird, auf welches das Modulationssignal aufmoduliert wird. Die in dem spannungsgesteuerten Oszillator verwendeten frequenzbestimmenden Bauteile (üblicherweise Kapazitätsdioden) unterliegen bestimmten Herstellungstoleranzen, die dazu führen, daß die Kennlinie bzw. deren Steilheit des spannungsgesteuerten Oszillators um bis ±100% schwanken kann.

Bei bekannten Sendevorrichtungen wird daher während der Fertigung der entsprechenden Sendevorrichtung bzw. des Geräts (z.B. eines Mobiltelefons), in dem die Sendevorrichtung eingesetzt ist, einmalig ein eigens zur Kalibrierung des Modulationshubs vorgesehener Abgleichschritt durchgeführt. Während dieses Abgleichschritts wird zunächst der aktuelle Modulationshub der Sendevorrichtung gemessen und anschließend der Modulationshub auf den gewünschten Wert abgeglichen, wobei hierzu das Modulationssignal beispielsweise mittels Lasertrimmung, mittels einstellbarer Widerstände oder digital mittels Software entsprechend eingestellt wird.

Dieser zusätzlich während der Fertigung durchzuführende Abgleichschritt ist relativ zeitaufwendig und kostspielig.

Der vorliegenden Erfindung liegt daher die Aufgabe zugrunde, eine Sendevorrichtung vorzuschlagen, die es ermöglicht, diesen Abgleichschritt während der Fertigung einzusparen.

Diese Aufgabe wird erfindungsgemäß durch eine Sendevorrichtung mit den Merkmalen des Anspruches 1 gelöst. Die Unteransprüche definieren vorteilhafte und bevorzugte Ausführungsbeispiele der vorliegenden Erfindung.

Die erfindungsgemäße Sendevorrichtung umfaßt eine Kalibriereinrichtung, die eine automatische Kalibrierung des Modulationssignals laufend während des Betriebs der Sendevorrichtung ermöglicht. Die Kalibriereinrichtung kann insbesondere derart ausgestaltet sein, daß durch die Kalibriereinrichtung kontinuierlich die Amplitude des Modulationssignals angepaßt wird.

Zur Erzeugung der Sendefrequenz wird vorzugsweise ein spannungsgesteuerter Oszillator mit Phasenregelkreis verwendet, wobei die Kalibriereinrichtung insbesondere die dem spannungsgesteuerten Oszillator von dem Phasenregelkreis zugeführte Steuerspannung mißt und davon abhängig den Modulationshub des Modulationssignals einstellt. Die Steuerspannung wird vorzugsweise gemessen, ehe das Modulationssignal auf das Steuersignal aufmoduliert wird. Die Bestimmung des Modulationshubs kann beispielsweise durch eine digitale Approximation der Kennlinie des spannungsgesteuerten Oszillators erfolgen.

Die vorliegende Erfindung ermöglicht, daß der bisher während der Fertigung durchzuführende Abgleichschritt entfallen kann, da erfindungsgemäß während des Betriebs laufend eine automatische Kalibrierung des Modulationssignals und damit des Modulationshubs erfolgt. Dies hat eine Einsparung der Fertigungszeit und damit auch der Fertigungskosten zur Folge.

Die vorliegende Erfindung kann auf Sendevorrichtungen mit analoger oder digitaler Modulation angewendet werden, Insbesondere eignet sich die vorliegende Erfindung zum Einsatz auf dem Gebiet der Mobilfunktechnik, beispielsweise in DECT- oder Bluetooth-Mobilfunksendern.

Die Erfindung wird nachfolgend anhand eines bevorzugten Ausführungsbeispiels unter Bezugnahme auf die beigefügte Zeichnung näher erläutert.

Fig. 1 zeigt ein vereinfachtes Blockschaltbild einer Sendevorrichtung gemäß der vorliegenden Erfindung, und

Fig. 2 zeigt eine Darstellung verschiedener Kennlinien von spannungsgesteuerten Oszillatoren.

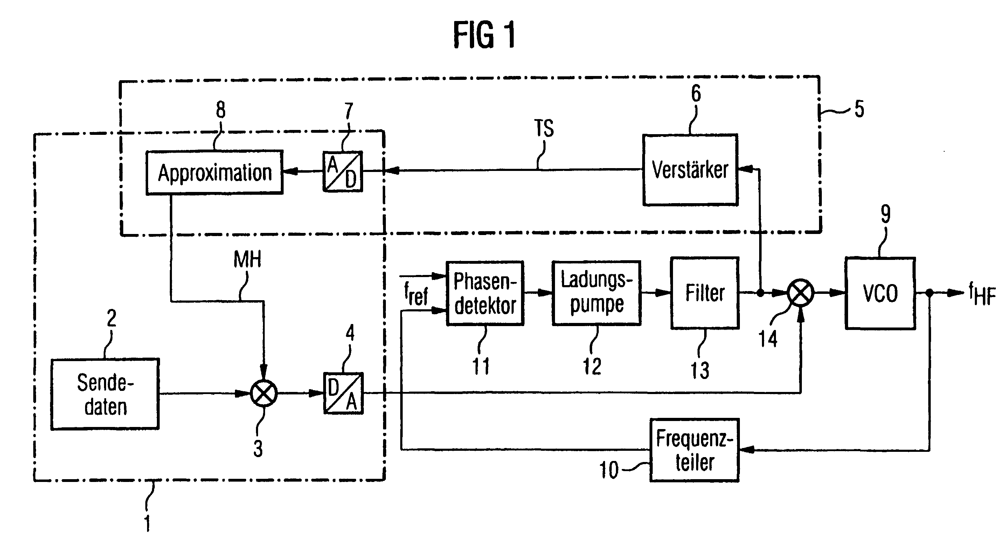

Die in Fig. 1 gezeigte Sendevorrichtung umfaßt im wesentlichen einen digitalen Sendeabschnitt 1 zur Erzeugung eines Modulationssignals in Abhängigkeit von zu sendenden Daten, einen Abschnitt zur Erzeugung einer hochfrequenten Sendefrequenz f_{HF} in Abhängigkeit von dem Modulationssignal und einen Kalibrierabschnitt 5 zur automatischen Kalibrierung des Modulationssignals.

Der digitale Sendeabschnitt 1 umfaßt eine Einrichtung 2 zur Erzeugung des Modulationssignals in Abhängigkeit von den Sendedaten, wobei das Modulationssignal über einen Multiplizierer 3 und einen Digital/Analog-Wandler (D/A-Wandler) 4 einem weiteren Multiplizierer oder Modulator 14 zugeführt wird.

Die hochfrequente Sendefrequenz f_{HF} wird von einem spannungsgesteuerten Oszillator (VCO) 9 erzeugt, der von einem Phasenregelkreis (PLL) 10-13 angesteuert wird. Der Phasenregelkreis umfaßt einen Frequenzteiler 10, der die von dem spannungsgesteuerten Oszillator 9 generierte Sendefrequenz f_{HF} gemäß einem vorgegebenen Teilerverhältnis teilt und einem Phasendetektor 11 zuführt. Der Phasendetektor 11 empfängt zudem eine Referenzfrequenz f_{ref}, mit welcher die von dem Frequenzteiler 10 heruntergeteilte Frequenz verglichen wird. Abhängig von dem Vergleichsergebnis wird ein Steuersignal für eine Ladungspumpe 12 erzeugt, von der wiederum über einen Tiefpaßfilter 13 eine entsprechende Abstimm- oder Tuning-Spannung für den spannungsgesteuerten Oszillator 9 ausgegeben wird. Auf diese Weise wird die von dem spannungsgesteuerten Oszillator 9 ausgegebene Sendefrequenz 9 unter Berücksichtigung des Teilerverhältnisses des Frequenzteilers 10 auf die Referenzfrequenz f_{ref} abgeglichen. Die Ausgestaltung des Phasenregelkreises spielt für die vorliegende Erfindung keine Rolle. Es kann beispielsweise sowohl ein 'klassischer' Phasenregelkreis als auch ein in Form einer "Fractional N Sigma Delta"-PLL ausgestalteter Phasenregelkreis eingesetzt werden.

Auf die dem spannungsgesteuerten Oszillator 9 zugeführte Tuning-Spannung wird mit Hilfe des bereits erwähnten Modulators 14 das Modulationssignal aufmoduliert.

Der Kalibrierabschnitt 5 umfaßt eine Einrichtung 6 zum Messen der Tuning-Spannung des spannungsgesteuerten Oszillators 9, wobei diese Einrichtung 6 beispielsweise durch einen Abtast-Halte-Verstärker (Sample-Hold-Verstärker) oder einen analogen Verstärker gebildet sein kann. Die Tuning-Spannung des spannungsgesteuerten Oszillators 9 wird vorzugsweise gemessen, bevor das Modulationssignal auf die Tuning-Spannung aufmoduliert wird.

Wird eine Sendevorrichtung verwendet, die im Gegensatz zu dem in Fig. 1 gezeigten Ausführungsbeispiel nicht in einem 'Closed Loop", sondern in einem 'Open Loop' arbeitet, bietet es sich an, die Tuning-Spannung des spannungsgesteuerten Oszillators vor dem Wechsel in den 'Open Loop' zu messen.

Die auf diese Weise gemessene analoge Tuning-Spannung TS wird über einen A/D-Wandler 7 einer Approximationseinrichtung 8 zugeführt. Die Approximationseinrichtung 8 führt eine digitale Approximation der Kennlinie des spannungsgesteuerten Oszillators 9 durch, um anhand der approximierten Kennlinie anschließend den notwendigen Modulationshub MH zu ermitteln. Die Amplitude des von der Einrichtung 2 erzeugten Modulationssignals wird in dem Multiplizierer 3 mit dem ermittelten Wert des Modulationshubs MH multipliziert, so daß die Amplitude des Modulationssignals laufend während des Betriebs automatisch kalibriert wird.

Anstelle des Multiplizierers 3 kann zur Einstellung der Amplitude des Modulationssignals in Abhängigkeit von dem Modulationshub MH auch ein Equalizer oder dergleichen verwendet werden. Darüber hinaus kann die vorliegende Erfindung beispielsweise auch auf Phasenregelkreise mit mehreren, insbesondere zwei, Kapazitätsdioden angewendet werden, welche über einen digitalen Algorithmus angepaßt ("gematched") werden. Kapazitätsdioden werden insbesondere bei größeren Frequenzbändern bevorzugt eingesetzt.

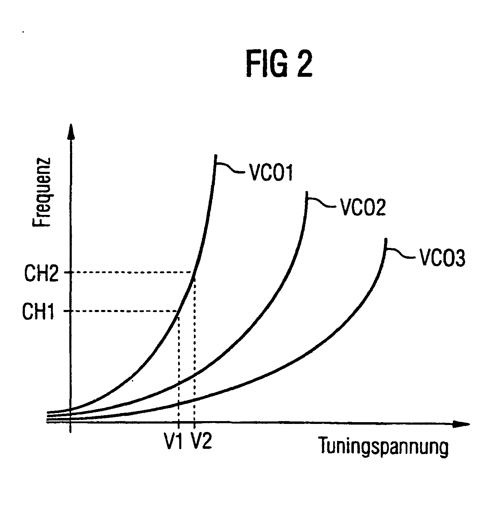

In Fig. 2 sind verschiedene Kennlinien VCO1...VCO3 des spannungsgesteuerten Oszillators 9 dargestellt, wobei jede Kennlinie die von dem spannungsgesteuerten Oszillator 9 erzeugte Sendefrequenz f_{HF} in Abhängigkeit von der Tuning-Spannung angibt. Durch eine Approximation der jeweiligen Kennlinie kann nach Messen der Tuning-Spannung einfach der zur Erzeugung einer bestimmten Sendefrequenz erforderliche Modulationshub MH ermittelt werden. In die Kennlinienapproximation können, soweit verfügbar, auch verschiedene Meßpunkte der jeweiligen Kennlinie eingehen, was beispielsweise bei Sendevorrichtungen mit mehreren Übertragungskanälen der Fall sein kann. In Fig. 2 sind diesbezüglich an der Kennlinie VCO1 zwei mögliche Übertragungskanäle CH1 und CH2 mit den jeweils entsprechenden Werten V1 bzw. V2 der Tuning-Spannung eingetragen.

## Patentansprüche

1. Sendevorrichtung, mit
- einer Modulationssignal-Erzeugungseinrichtung (2,3), um in Abhängigkeit von zu sendenden Daten ein Modulationssignal zu erzeugen,
- einer Sendefrequenz-Erzeugungseinrichtung (9), welche in Abhängigkeit von dem Modulationssignal angesteuert wird und eine dem Modulationssignal entsprechende Sendefrequenz (f_{HF}) erzeugt, und
- einer Kalibriereinrichtung (5) zur automatischen Kalibrierung des Modulationssignals, welche eine Messeinrichtung (6) zum Messen eines der Sendefrequenz-Erzeugungseinrichtung (9) zuzuführenden Steuersignals und eine Modulationshub-Ermittlungseinrichtung (8) aufweist,
**dadurch gekennzeichnet,**
- **dass** die Messeinrichtung (6) das der Sendefrequenz-Erzeugungseinrichtung (9) zuzuführende Steuersignal an einem Punkt abgreift, bevor dieses in einem Multiplizierer (14) mit dem Modulationssignal multipliziert wird,
- **dass** die Modulationshub-Ermittlungseinrichtung (8) für eine digitale Approximation der Kennlinie der Sendefrequenz-Erzeugungseinrichtung (9) und für eine digitale Ermittlung des Modulationshubwertes (MH) ausgelegt ist, und
- die Modulationssignal-Erzeugungseinrichtung (2, 3) eine Sendedaten-Erzeugungseinrichtung (2) und einen digitalen Multiplizierer (3) oder einen Equalizer aufweist, welcher mit der Sendedaten-Erzeugungseinrichtung (2) und der Modulationshub-Ermittlungseinrichtung (8) verbunden ist.

2. Sendevorrichtung nach Anspruch 1,
**dadurch gekennzeichnet,**
**daß** die Modulationshub-Ermittlungseinrichtung (8) den Modulationshubwert (MH) für das Modulationssignal durch eine Approximation der Kennlinie der Sendefrequenz-Erzeugungseinrichtung (9) ermittelt.

3. Sendevorrichtung nach Anspruch 1 oder 2,
**dadurch gekennzeichnet,**
**daß** das Modulationssignal dem Steuersignal durch eine Modulationseinrichtung (14) aufmoduliert wird.

4. Sendevorrichtung nach einem der Ansprüche 1 bis 3,
**dadurch gekennzeichnet,**
**daß** die Meßeinrichtung (6) zum Messen des der Sendefrequenz-Erzeugungseinrichtung (9) zugeführten Steuersignals (TS) einen Abtast-Halte-Verstärker umfaßt.

5. Sendevorrichtung nach einem der Ansprüche 1 bis 3,
**dadurch gekennzeichnet,**
**daß** die Meßeinrichtung (6) zum Messen des der Sendefrequenz-Erzeugungseinrichtung (9) zugeführten Steuersignals (TS) einen analogen Verstärker (9) umfaßt.

6. Sendevorrichtung nach einem der Ansprüche 1 bis5,
**dadurch gekennzeichnet,**
**daß** ein Phasenregelkreis (10-13) zum Erzeugen und Regeln des Steuersignals (TS) für die Sendefrequenz-Erzeugungseinrichtung (9) vorgesehen ist, dem einerseits die von der Sendefrequenz-Erzeugungseinrichtung (9) erzeugte Sendefrequenz (f_{HF}) und andererseits eine Referenzfrequenz (f_{ref}) zugeführt ist und der abhängig von dem Verhältnis der Sendefrequenz (f_{HF}) zu der Referenzfrequenz (f_{ref}) das Steuersignal (TS) erzeugt.

7. Sendevorrichtung nach Anspruch 6,
**dadurch gekennzeichnet,**
**daß** der Phasenregelkreis (10-13) in Form eines "Fractional N Sigma-Delta"-Phasenregelkreises ausgestaltet ist.

8. Sendevorrichtung nach einem der Ansprüche 3-7,
**dadurch gekennzeichnet,**
**daß** die Meßeinrichtung (6) das Steuersignal (TS) vor der Modulationseinrichtung (14) abgreift und mißt.

9. Verwendung einer Sendevorrichtung nach einem der vorhergehenden Ansprüche in einem Mobilfunksender, insbesondere in einem DECT- oder Bluetooth-Mobilfunksender.

## Claims

1. Transmitting device, with
- a modulation signal generation device (2, 3) for generating a modulation signal depending on data to be transmitted,
- a transmission frequency generation device (9) which is controlled depending on the modulation signal and which generates a transmission frequency (f_{HF}) corresponding to the modulation signal, and
- a calibration device (5) for automatic calibration of the modulation signal, which has a measuring device (6) for measuring a control signal to be fed to the transmission frequency generation device (9), and a modulation sweep determining device (8),
**characterized in that**
- the measuring device (6) taps off the control signal to be fed to the transmission frequency generation device (9) at one point before this signal is multiplied by the modulation signal in a multiplier (14),
- the modulation sweep determining device (8) is designed for digital approximation of the curve of the transmission frequency generation device (9) and for digital determination of the modulation sweep value (MH), and
- the modulation signal generation device (2, 3) has a transmission data generation device (2) and a digital multiplier (3) or an equalizer, which is connected to the transmission data generation device (2) and to the modulation sweep determining device (8) .

2. Transmitting device according to Claim 1,
**characterized in that**
the modulation sweep determining device (8) determines the modulation sweep value (MH) for the modulation signal through an approximation of the curve of the transmission frequency generation device (9).

3. Transmitting device according to Claim 1 or 2,
**characterized in that**
the modulation signal is modulated onto the control signal by means of a modulation device (14).

4. Transmitting device according to one of Claims 1 to 3,
**characterized in that**
the measuring device (6) for measuring the control signal (TS) fed to the transmission frequency generation device (9) comprises a sample-hold amplifier.

5. Transmitting device according to one of Claims 1 to 3,
**characterized in that**
the measuring device (6) for measuring the control signal (TS) fed to the transmission frequency generation device (9) comprises an analogue amplifier (9) .

6. Transmitting device according to one of Claims 1 to 5,
**characterized in that**
a phase-locked loop (10-13) is provided to generate and adjust the control signal (TS) for the transmission frequency generation device (9), to which, on the one hand, the transmission frequency (f_{HF}) generated by the transmission frequency generation device (9) and, on the other hand, a reference frequency (f_{ref}) are fed, and which generates the control signal (TS) depending on the ratio of the transmission frequency (f_{HF}) to the reference frequency (f_{ref}).

7. Transmitting device according to Claim 6,
the phase-locked loop (10-13) is designed in the form of a "Fractional N Sigma Delta" phase-locked loop.

8. Transmitting device according to one of Claims 3-7,
**characterized in that**
the measuring device (6) taps and measures the control signal (TS) upstream of the modulation device (14).

9. Use of a transmitting device as claimed in one of the preceding claims in a mobile radio transmitter, in particular in a DECT or Bluetooth mobile radio transmitter.

## Revendications

1. Dispositif d'émission comportant :
- un dispositif de génération de signal de modulation (2, 3), destiné à générer un signal de modulation en fonction des données à transmettre,
- un dispositif de génération de fréquence d'émission (9), qui est commandé en fonction du signal de modulation et qui génère une fréquence d'émission (f_{HF}) correspondant au signal de modulation, et,
- un dispositif d'étalonnage (5), destiné à étalonner automatiquement le signal de modulation, lequel dispositif d'étalonnage comporte un dispositif de mesure (6) destiné à mesurer un signal de commande, qui doit être amené au dispositif de génération de fréquence d'émission (9), et un dispositif (8) de détermination de l'amplitude de modulation,
**caractérisé en ce que** :
- le dispositif de mesure (6) prélève le signal de commande qui doit être amené au dispositif de génération de fréquence d'émission (9) en un point avant de multiplier ce signal par le signal de modulation dans un multiplicateur (14),
- le dispositif (8) de détermination de l'amplitude de modulation est conçu pour effectuer une approximation numérique de la caractéristique du dispositif de génération de fréquence d'émission (9) et pour effectuer une détermination numérique de la valeur (MH) de l'amplitude de modulation, et
- le dispositif de génération de signal de modulation (2, 3) comporte un dispositif de génération de données d'émission (2) et un multiplicateur numérique (3) ou un égalisateur qui est relié au dispositif de génération de données d'émission (2) et au dispositif (8) de détermination de l'amplitude de modulation.

2. Dispositif d'émission selon la revendication 1,**caractérisé en ce que** le dispositif (8) de détermination de l'amplitude de modulation détermine la valeur (MH) de l'amplitude de modulation pour le signal de modulation par une approximation de la caractéristique du dispositif de génération de fréquence émission (9).

3. Dispositif d'émission selon la revendication 1 ou 2,**caractérisé en ce que** le signal de modulation module le signal de commande au moyen d'un dispositif de modulation (14).

4. Dispositif d'émission selon l'une des revendications 1 à 3,**caractérisé en ce que** le dispositif de mesure (6) destiné à mesurer le signal de commande (TS) amené au dispositif de génération de fréquence d'émission (9) comporte un amplificateur échantillonneur-bloqueur.

5. Dispositif d'émission selon l'une des revendications 1 à 3,**caractérisé en ce que** le dispositif de mesure (6) destiné à mesurer le signal de commande (TS) amené au dispositif de génération de fréquence d'émission (9) comporte un amplificateur analogique (9).

6. Dispositif d'émission selon l'une des revendications 1 à 5, **caractérisé en ce qu'**il est prévu un circuit de régulation de phase (10-13), qui est destiné à générer et réguler le signal de commande (TS) pour le dispositif de génération de fréquence d'émission (9), auquel sont amenées d'une part la fréquence d'émission (f_{HF}) générée par le dispositif de génération de fréquence d'émission (9) et d'autre part une fréquence de référence (f_{ref}), et qui génère le signal de commande (TS) en fonction du résultat du rapport entre la fréquence d'émission (f_{HF}) et la fréquence de référence (f_{ref}).

7. Dispositif d'émission selon la revendication 6, **caractérisé en ce que** le circuit de régulation de phase (10-13) est conformé en circuit de régulation de phase « Fractional N Sigma-Delta ».

8. Dispositif d'émission selon l'une des revendications 3 à 7, **caractérisé en ce que** le dispositif de mesure (6) prélève et mesure le signal de commande (TS) avant le dispositif de modulation (14).

9. Utilisation d'un dispositif d'émission selon l'une des revendications précédentes dans un émetteur de radiotéléphonie mobile, en particulier dans un émetteur de radiotéléphonie mobile DECT ou Bluetooth.
